# EUROPÄISCHE PATENTSCHRIFT

(11) **EP 0 473 242 B1**
(45) Veröffentlichungstag und Bekanntmachung des Hinweises auf die Patenterteilung: **26.04.1995**
(21) Anmeldenummer: 91250194.7
(22) Anmeldetag: 18.07.1991
(51) Int. Cl.: H05K 5/00

(54) **Schutzgehäuse mit einem darin enthaltenen Elektronikbaustein**
Protective housing comprising an electronic construction unit
Boîtier de protection comprenant une pièce détachée électronique

(30) Priorität: 27.07.1990 DE 4024349
(43) Veröffentlichungstag der Anmeldung: 04.03.1992
(73) Patentinhaber: SIEMENS AKTIENGESELLSCHAFT, 80333 München (DE)
(72) Erfinder: Kontants, Horst, W-2900 Oldenburg (DE); Waespy, Wolfgang, W-2800 Bremen (DE)

(56) Entgegenhaltungen:
- EP-A- 0 071 233
- EP-A- 0 308 676
- EP-A- 0 345 208
- DE-U- 7 919 535
- DE-U- 8 300 516

## Beschreibung

Der Einsatz von elektrischen und/oder elektronischen Bausteinen in technischen Geräten, die im Freien betrieben werden, insbesondere in Fahrzeugen jeder Art verlangt einen Schutz dieser Bausteine gegen Umwelteinflüsse wie Feuchtigkeit, Steinschlag, Staub sowie Stoß- und Rüttelbelastung. Beispielsweise ist ein entsprechender Schutz für die Auswerteelektronik eines Überwachungsorgans notwendig, das zur Erfassung des Abriebes eines Bremsbelages in Kraftfahrzeugen dient und bei dem die in einem Baustein zusarnmengefaßte Auswerteelektronik in einem dem Fühlerelement zugeordneten, am Kraftfahrzeug fixierbaren Kunststoffgehäuse angeordnet ist. Die Auswerteelektronik und das Fühlerelement sind dabei über eine elektrische Leitung, insbesondere eine Flachbandleitung miteinander verbunden, während das Gehäuse zusätzlich mit Steckbuchsen zum Anschluß entsprechender Verbindungsleitungen versehen ist (DE-OS 38 18 877/EP 0 345 208 A1).

Zum Schutz und zur mechanischen Halterung eines Temperaturfühlers für eine Waschmaschine ist bereits ein becherförmiges Metallgehäuse bekannt, in das der Temperaturfühler mit Hilfe eines die Anschlußdrähte umfassenden elastischen Isolierteiles eingesetzt ist. Das Isolierteil ist dabei mit einer Verdickung versehen, in deren Bereich es vom Metallgehäuse klemmend umfaßt wird. Anschlußstifte, die im Bereich der Verdickung des Isolierteiles mit den Anschlußdrähten des Temperaturfühlers klemmend verbunden sind, sind im Bereich eines hohlzylindrischen Ansatzes des Isolierteiles am offenen Ende des Metallgehäuses gemeinsam nach außen geführt (DE-U 79 19 535).

Ausgehend von einem Schutzgehäuse mit den Merkmalen des Oberbegriffes des Patentanspruches 1 liegt der Erfindung die Aufgabe zugrunde, das Schutzgehäuse so auszugestalten, daß es bei leichter Montierbarkeit einen wirksamen Schutz des Elektronikbausteines gegen mechanische und chemische Umwelteinflüsse gewährleistet.

Zur Lösung dieser Aufgabe ist gemäß der Erfindung vorgesehen, daß das Schutzgehäuse aus einem den Elektronikbaustein umschließenden Innengehäuse und aus einem Außengehäuse besteht, daß das Innengehäuse aus gummielastischem Kunststoff besteht und mit Luftkammern versehen ist, daß weiterhin das Außengehäuse aus einem duroplastischen oder thermoelastischen Kunststoff besteht und das Innengehäuse mit Druck umgibt und daß schließlich das Innengehäuse mit wenigstens einem Ansatz versehen ist, in den der Anschluß eingebettet und durch den hindurch der Anschluß nach außen geführt ist.

Bei einer derartigen Ausgestaltung des Schutzgehäuses wird durch die Verwendung eines gummielastischen, mit Luftkammern versehenen Innengehäuses der mechanische Schutz und durch die Kombination eines gummielastischen Innengehäuses und eines harten Außengehäuses der Feuchtigkeitsschutz gewährleistet. Der für die Feuchtigkeitsabdichtung erforderliche Druck wird dabei zweckmäßig in der Weise erzeugt, daß das Außengehäuse aus wenigstens zwei miteinander verbindbaren Teilen besteht, deren Innenabmessungen kleiner als die entsprechenden Außenabmessungen des Innengehäuses sind. Beispielsweise kann das Außengehäuse aus zwei Halbschalen oder aus einem wannenartigen und einem deckelartigen Teil bestehen, die unter Deformation des gummielastischen, mit Luftkammern versehenen Innengehäuses form- oder stoffschlüssig miteinander verbunden werden. Besonders zweckmaßig hierfür ist die Verwendung eines Außengehäuses aus einem becherförmigen Teil und einem damit verbindbaren deckelförmigen Teil. Ein solches Außengehäuse - bei dem das deckelförmige Teil mit dem becherförmigen Teil verrastbar sein kann und das deckelförmige Teil auch aus zwei miteinander verrastbaren Deckelhälften bestehen kann, die gegebenenfalls am becherförmigen Teil schwenkbar befestigt sind - ist besonders für Anwendungsfälle geeignet, bei denen der Elektronikbaustein sowohl mit einem Anschluß in Form einer nach außen geführten Anschlußleitung als auch mit zwei oder mehr Anschlüssen in Form von Steckkontakten versehen ist, die in dem Innengehäuse gelagert und jeweils innerhalb eines rohrförmigen Ansatzes des Außengehäuses nach außen geführt sind. Bei der Montage eines solchen Schutzgehäuses wird das Innengehäuse mit dem die Steckanschlüsse aufweisenden Bereich zunächst in das becherförmige Teil des Außengehäuses eingeführt, das auch die rohrförmigen Ansätze aufweist, anschließend wird das deckelförmige Teil des Außengehäuses um einen die Anschlußleitung führenden, nach außen ragenden Ansatz des Innengehäuses gelegt und unter Druck mit dem becherförmigen Teil verrastet. - An sich kann das Schutzgehäuse aber auch nur mit Steckanschlüssen oder nur mit einem Anschluß in Form einer elektrischen Leitung versehen sein.

Die in dem Innengehäuse vorgesehenen Luftkammern werden zweckmäßig dadurch hergestellt, daß das Innengehäuse aus einem quaderförmigen Mittelteil und je einem deckelartigen Ober- und Unterteil besteht, wobei in dem Mittelteil Sacklöcher und am Unter- und Oberteil Stopfen zum Verschließen der Sacklöcher vorgesehen sind. Dabei empfiehlt es sich, einige der Löcher und Stopfen nach Art eines Druckknopfes zusammenwirken zu lassen. Bezüglich Herstellung und Montage eines solchen Innengehäuses ist von Vorteil, wenn das Oberteil und das Unterteil des Innengehäuses jeweils über ein Filmscharnier einstückig mit dem Mittelteil verbunden sind.

Für die Praxis hat sich insbesondere ein Schutzgehäuse bewährt, dessen Außengehäuse aus einem Polyamid und dessen Innengehäuse aus Silikonkautschuk besteht, wobei zur Herstellung des Innengehäuses mit Rücksicht auf eine niedrige Verarbeitungstemperatur und einen niedrigen Verarbeitungsdruck sowie mit Rücksicht auf die gewünschte Temperaturfestigkeit zweckmäßig ein Flüssigsilikon zur Anwendung gelangt.

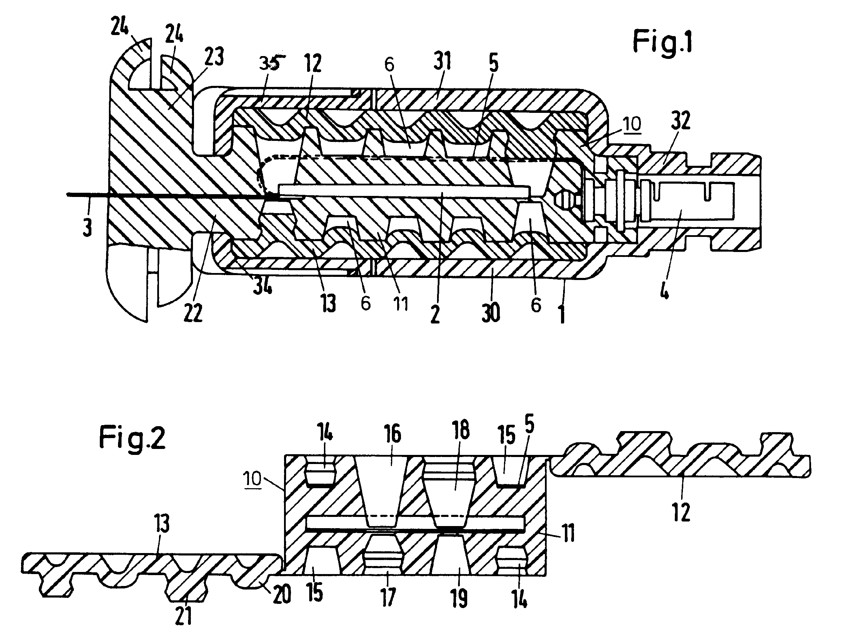

Ein Ausführungsbeispiel des neuen Schutzgehäuses ist in den Figuren 1 und 2 dargestellt. Dabei zeigt
- Figur 1: einen Längsschnitt durch das montierte Schutzgehäuse und
- Figur 2: einen Querschnitt durch das Innengehäuse.
- Figur 3: zeigt eine Draufsicht auf das nicht montierte Innengehäuse.

Gemäß Figur 1 umgibt das Schutzgehäuse 1 einen Elektronikbaustein 2, an den sowohl eine elektrische Leitung 3 in Form einer Flachleitung als auch - über Verbindungsleitungen 5 - Steckkontakte 4 angeschlossen sind.

Das Schutzgehäuse 1 besteht aus einem Innengehäuse 10 aus gummielastischem Kunststoff und einem Außengehäuse 30 aus einem duroplastischen oder thermoelastischen Kunststoff. Wie insbesondere der Darstellung in Figur 2 zu entnehmen ist, wird das Innengehäuse 10 von einem Mittelteil 11, einem deckelartigen Oberteil 12 und einem deckelartigen Unterteil 13 gebildet. Im blockartig gestalteten Mitteilteil 11 sind eine Vielzahl von Sacklöchern 14 bis 19 unterschiedlicher Größe vorgesehen. Das deckelartige Oberteil 12 und das deckelartige Unterteil 13 sind mit Noppen bzw. Stopfen 20 und 21 versehen und jeweils über ein nicht näher bezeichnetes Filmscharnier mit dem Mittelteil 11 verbunden. Einige der Sacklöcher und der Stopfen sind so ausgebildet, daß sie nach Art eines Druckknopfes zusammenwirken, wenn die deckelartigen Teile 12 und 13 zur Bildung von Luftkammern 6 auf das Mittelteil 11 geklappt werden. Ein Teil der Sacklöcher entsteht durch die Verwendung von Kernen, die bei der Herstellung des Innengehäuses auch zur Fixierung des Elektronikbausteines in der Gieß- bzw. Spritzform dienen.

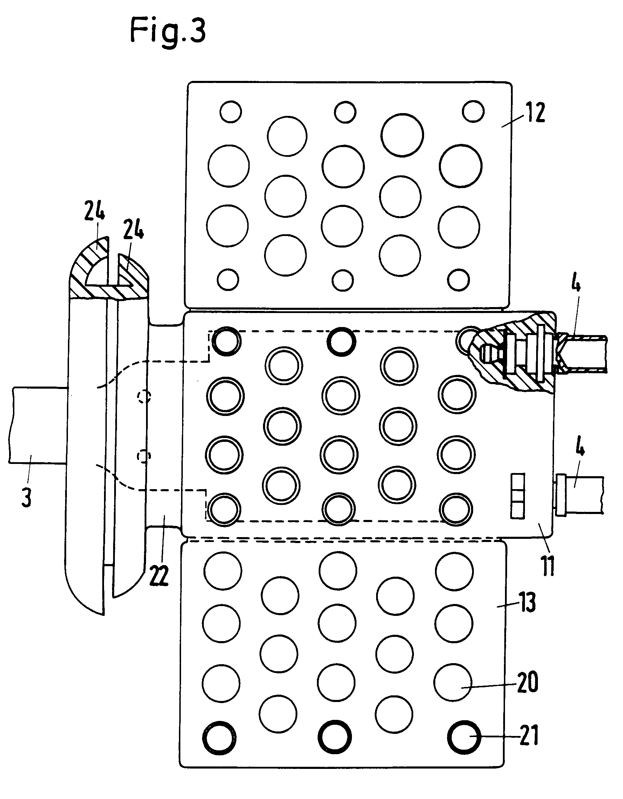

Figur 3 zeigt eine Draufsicht des gummielastischen Innengehäuses im aufgeklappten Zustand. Danach sind die Steckkontakte 4 in einem nicht näher bezeichneten Ansatz des Mitelteiles 11 eingebettet, während an dem gegenüberliegenden Ende des Mittelteiles 11 der Ansatz 22 vorgesehen ist, durch den hindurch die Leitung 3 nach außen geführt ist. Der Ansatz 22 dient damit zugleich als Knickschutz für die Leitung 3. Der Ansatz 22 weist im übrigen einen Flansch 23 mit ringförmigen Haltelippen 24 auf. Mittels dieser Haltelippen kann das Schutzgehäuse in einer entsprechenden Ausnehmung der Wand eines technischen Gerätes elastisch fixiert werden.

Das Außengehäuse 30 des Schutzgehäuses 1 besteht aus einem becherförmigen Teil 31, der mit rohrförmigen Ansätzen 32 zur Herausführung der Steckkontakte 4 versehen ist, und aus einem deckelförmigen Teil, das aus den beiden Deckelhälften 34 und 35 besteht. Diese beiden Deckelhälften sind in nicht näher dargestellter Weise im Bereich des Ansatzes 22 miteinander verrastbar und über nicht näher bezeichnete nasenförmige Ansätze und entsprechende hakenförmige Ansätze am becherförmigen Teil 31 mit diesem verrastbar. Die Innenabmessungen des Außengehäuses 30 sind dabei kleiner als die Außenabmessungen des Innengehäuses, so daß beim Verschließen des Außengehäuses auf das Innengehäuse auch im Bereich der Steckkontakte 4 ein Druck ausgeübt wird.

## Patentansprüche

1. Aus Kunststoff bestehendes Schutzgehäuse (1) mit einem darin enthaltenen Elektronikbaustein (2), der mit wenigstens einem nach außen geführten elektrischen Anschluß (3) versehen und mit Hilfe des Schutzgehäuses (1) an einem technischen Gerät fixierbar ist,
**dadurch gekennzeichnet,**
daß das Schutzgehäuse (1) aus einem den Elektronikbaustein (2) umschließenden Innengehäuse (10) aus gummielastischem Kunststoff besteht und mit Luftkammern (6) versehen ist, daß das Außengehäuse (30) aus einem duroplastischen oder thermoelastischen Kunststoff besteht und das Innengehäuse (10) mit Druck umgibt
und daß das Innengehäuse (10) mit wenigstens einem Ansatz (22) versehen ist, in den der Anschluß (3) eingebettet und durch den hindurch der Anschluß (3) nach außen geführt ist.

2. Schutzgehäuse nach Anspruch 1,
**dadurch gekennzeichnet,**
daß der Elektronikbaustein (2) mit zwei oder mehr Anschlüssen in Form von Steckkontakten (4) versehen ist, die in dem Innengehäuse (10) gelagert und jeweils innerhalb eines rohrförmigen Ansatzes (32) des Außengehäuses (30) nach außen geführt sind.

3. Schutzgehäuse nach Anspruch 1 oder 2,
**dadurch gekennzeichnet,**
daß ein Ansatz (22) des Innengehäuses (10) nach außen ragt und daß ein Anschluß des Elektronikbausteines (2) aus einer Anschlußleitung (3) besteht, die durch den nach außen ragenden Ansatz (22) hindurch nach außen geführt ist.

4. Schutzgehäuse nach einem der Ansprüche 1 bis 3, **dadurch gekennzeichnet,** daß das Innengehäuse (10) aus einem quaderförmigen Mittelteil (11) und je einem deckelartigen Ober- und Unterteil (12,13) besteht,
wobei in dem Mittelteil des Innengehäuses Sacklöcher (14 - 19) und am Unter- und Oberteil Stopfen (20, 21) zum Verschließen der Sacklöcher vorgesehen sind.

5. Schutzgehäuse nach Anspruch 4, **dadurch gekennzeichnet,** daß einige der Löcher (14 - 19) und Stopfen (20,21) nach Art eines Druckknopfes zusammenwirken.

6. Schutzgehäuse nach Anspruch 4 oder 5, **dadurch** **gekennzeichnet,** daß das Oberteil (12) und das Unterteil (13) jeweils über ein Filmscharnier einstückig mit dem Mittelteil (11) verbunden sind.

7. Schutzgehäuse nach einem der Ansprüche 3 bis 6, **dadurch gekennzeichnet,** daß der Ansatz (22 ) des Innengehäuses (10) zur Fixierung des Schutzgehäuses (1) an einem technischen Gerät dient und hierzu einen scheibenförmigen Flansch (23) aufweist, der mit ringförmigen Haltelippen (24) versehen ist.

8. Schutzgehäuse nach einem der Ansprüche 1 bis 7, **dadurch gekennzeichnet,** daß das Außengehäuse (30) aus wenigstens zwei miteinander verbindbaren Teilen (31, 34, 35) besteht, deren Innenabmessungen kleiner als die entsprechenden Außenabmessungen des Innengehäuses (10) sind.

9. Schutzgehäuse nach Anspruch 8, **dadurch gekennzeichnet,** daß das Außengehäuse (30) aus einem becherförmigen Teil (31) und einem damit verbindbaren deckelförmigen Teil (34, 35) besteht, wobei der Ansatz (22) des Innengehäuses durch das deckelförmige Teil nach außen geführt ist.

10. Schutzgehäuse nach einem der Ansprüche 1 bis 9, **dadurch gekennzeichnet,** daß das Innengehäuse (10) aus Silikonkautschuk und das Außengehäuse (30) aus Polyamid besteht.

## Claims

1. Protective housing (1) consisting of plastics material and having an electronics module (2) which is contained therein, is provided with at least one electrical connection (3) guided outwards and can be fixed to a technical device with the aid of the protective housing (1), characterised in that the protective housing (1) consists of an inner housing (10) which encloses the electronics module (2), consists of rubber elastic plastics material and is provided with air chambers (6), in that the outer housing (30) consists of a thermosetting or thermoelastic plastics material and surrounds the inner housing (10) with pressure, and in that the inner housing (10) is provided with at least one extension (22) into which the connection (3) is embedded and through which the connection (3) is guided outwards.

2. Protective housing according to claim 1, characterised in that the electronics module (2) is provided with two or more connections in the form of plug-in contacts (4) which are mounted in the inner housing (10) and in each case are guided outwards within a tubular extension (32) of the outer housing (30).

3. Protective housing according to claim 1 or 2, characterised in that an extension (22) of the inner housing (10) projects outwards and in that a connection of the electronics module (2) consists of a connection line (3) which is guided outwards through the extension (22) projecting outwards.

4. Protective housing according to one of the claims 1 to 3, characterised in that the inner housing (10) consists of a parallelepiped-block-shaped central portion (11) and a respective lid-like upper portion and lower portion (12, 13), with blind holes (14 - 19) being provided in the central portion of the inner housing and stoppers (20, 21) being provided on the lower portion and upper portion in order to seal the blind holes.

5. Protective housing according to claim 4, characterised in that some of the holes (14 - 19) and stoppers (20, 21) cooperate in the manner of a press-stud.

6. Protective housing according to claim 4 or 5, characterised in that the upper portion (12) and the lower portion (13) are each connected in one piece with the central portion (11) by way of a film hinge.

7. Protective housing according to one of the claims 3 to 6, characterised in that the extension (22) of the inner housing (10) is used to fix the protective housing (1) to a technical device and for this purpose has a disk-shaped flange (23) which is provided with annular holding lips (24).

8. Protective housing according to one of the claims 1 to 7, characterised in that the outer housing (30) consists of at least two portions (31, 34, 35) which can be connected together and the inside dimensions of which are smaller than the corresponding outside dimensions of the inner housing (10).

9. Protective housing according to claim 8, characterised in that the outer housing (30) consists of a cup-shaped portion (31) and a lid-shaped portion (34, 35) which can be connected therewith, with the extension (22) of the inner housing being guided outwards through the lid-shaped portion.

10. Protective housing according to one of the claims 1 to 9, characterised in that the inner housing (10) consists of silicone rubber and the outer housing (30) consists of polyamide.

## Revendications

1. Boîtier de protection (1) en matière plastique, dans lequel est logé un module électronique (2) muni d'au moins d'une borne (3) électrique guidée vers l'extérieur et pouvant être fixé à un appareil technique à l'aide du boîtier de protection (1), caractérisé par le fait
que le boîtier de protection (1) est constitué par un boîtier intérieur (10) entourant le module électronique (2) et en une matière plastique ayant l'élasticité du caoutchouc et est pourvu de chambres à air (6),
que le boîtier extérieur (30) est en matière thermodurcissable ou en une matière plastique thermoélastique et entoure, sous pression, le boîtier intérieur (10), et que le boîtier intérieur (10) comporte au moins un prolongement (22), dans lequel est insérée la borne (3) et à travers lequel la borne (3) est guidée à l'extérieur.

2. Boîtier de protection suivant la revendication 1, caractérisé par le fait que le module électronique (2) est muni de deux bornes ou d'un plus grand nombre de bornes sous la forme de contacts à enfichage (4), qui sont montées dans le boîtier intérieur (10) et qui sont guidées vers l'extérieur en passant respectivement à l'intérieur d'un prolongement tubulaire (32) du boîtier extérieur (30).

3. Boîtier de protection suivant la revendication 1 ou 2, caractérisé par le fait qu'un prolongement (22) du boîtier intérieur (11) fait saillie à l'extérieur et qu'une borne du module électronique (2) est constituée d'un conducteur de raccordement (3), qui est guidé vers l'extérieur en passant dans le prolongement (22) qui fait saillie extérieurement.

4. Boîtier de protection suivant l'une des revendications 1 à 3, caractérisé par le fait que le boîtier intérieur (10) est constitué d'une partie médiane de forme parallélépipédique (11) et respectivement d'une partie supérieure et d'une partie inférieure (12,13) en forme de couvercles,
des trous borgnes (14 à 19) étant aménagés dans la partie médiane du boîtier intérieur, tandis que des bouchons (20,21) servant à fermer les trous borgnes sont prévus à la partie inférieure et à la partie supérieure.

5. Boîtier de protection suivant la revendication 4, caractérisé par le fait que certains des trous (14 à 19) et des bouchons (20,21) coopèrent à la manière d'un bouton-pression.

6. Boîtier de protection suivant la revendication 4 ou 5, caractérisé par le fait que la partie supérieure (12) et la partie inférieure (13) sont reliées d'un seul tenant à la partie médiane (11), respectivement par l'intermédiaire d'une charnière souple.

7. Boîtier de protection suivant l'une des revendications 3 à 6, caractérisé par le fait que le prolongement (22) du boîtier intérieur (10) sert à fixer le boîtier de protection (1) sur un appareil technique et est muni, à cet effet, d'une bride en forme de disque (23), qui comporte des lèvres annulaires de maintien (24).

8. Boîtier de protection suivant l'une des revendications 1 à 7, caractérisé par le fait que le boîtier extérieur (30) est constitué d'au moins deux parties (31,34,35) pouvant être reliées entre elles et dont les dimensions intérieures sont inférieures aux dimensions extérieures correspondantes du boîtier intérieur (10).

9. Boîtier de protection suivant la revendication 8, caractérisé par le fait que le boîtier extérieur (30) est constitué d'une partie en forme de pot (31) et d'une partie formant couvercle (34,35) et pouvant y être reliée, le prolongement (22) du boîtier intérieur faisant saillie à l'extérieur en traversant la partie formant couvercle.

10. Boîtier de protection suivant l'une des revendications 1 à 9, caractérisé par le fait que le boîtier intérieur (10) est en caoutchouc de silicone et le boîtier extérieur (30) est en polyamide.
